# EUROPEAN PATENT SPECIFICATION

(11) **EP 2 390 609 B1**
(45) Date of publication and mention of the grant of the patent: **18.11.2020**
(21) Application number: 11165561.9
(22) Date of filing: 10.05.2011
(51) Int. Cl.: F28D 1/03, F28F 3/12, F28F 3/04, F28F 7/02

(54) **A cooling device**
Kühlvorrichtung
Dispositif de refroidissement

(30) Priority: 28.05.2010 SE 1050537
(43) Date of publication of application: 30.11.2011
(73) Proprietor: Webra Technology AB, 745 31 Enköping (SE)
(72) Inventor: Eriksson, Gunno, 734 33 Hallstahammar (SE)
(74) Representative: Bjerkéns Patentbyrå KB (Gävle)

(56) References cited:
- EP-A1- 1 926 143
- DE-A1-102007 008 864
- US-A- 5 042 257
- US-A- 6 009 938
- US-A1- 2005 247 432

## Description

### FIELD OF THE INVENTION

The present invention relates to a cooling device including a cooling surface adapted to be in contact with a component to be cooled, wherein the device comprises a first extruded piece including a plurality of grooves and a second extruded piece including a plurality of protruding elements extending into the grooves of the first piece, the first and second pieces are joined together and the protruding elements and the corresponding grooves are designed such that a plurality of flow channels for transportation of a cooling fluid are formed between the grooves and corresponding protruding elements.

### PRIOR ART

Cooling devices are used in many different applications for cooling different subjects. One important application is cooling of electronic equipment and components. Another application is in heat exchanges in which the cooling device is used to cool a warmer liquid. With the term cooling fluid is meant a cooling liquid, such as water, glycol, or oil.

The cooling device is provided with a plurality of channels for transporting the cooling fluid through the device in order keep the device cold. The purpose of the cooling device is to transfer heat from the component, which is to be cooled, to the cooling fluid. The channels can, for example, be manufactured by drilling a plurality of holed through the device. The cross section of the drilled channels will be circular.

EP1926143 discloses a cooling unit for semi-conductor components and a method for its manufacture. The cooling unit includes a first extruded piece including a plurality of grooves and a second extruded piece including a plurality of protruding elements extending into the grooves of the first piece, the first and second pieces being joined together. The protruding elements and the corresponding grooves are designed such that a plurality of flow channels for transportation of a cooling fluid are formed between them. The flow channels have a triangular cross section. A disadvantage with this cooling device is that it has a poor cooling capacity.

In order to achieve an efficient cooling, the wall area of the channel should be as large as possible in relation to the volume of the channel. Therefore, it is a desire to provide thin channels with a large height. This shape of the channels reduces the cooling fluid needed with maintained water velocity, and thus achieves an improved cooling.

US6,671,957 discloses a method for manufacturing cooling devices for mounting on semiconductor devices. The cooling devices are made from several extruded shaped section part elements. The section part elements have grooves and bead strips, wherein these grooves and bead strips are fitted into each other by applying pressure in a transverse direction. The channels formed are elongated and extending orthogonal to the cooling surface. A disadvantage with this cooling device is that it is complicated to manufacture. A further improvement of the cooling capacity is desired.

Document US 5042257 A shows a cooling device with the features of the preamble of claim 1.

### OBJECTS AND SUMMARY OF THE INVENTION

One object of the present invention is therefore to provide a cooling device which has an increased cooling capacity.

This object is achieved by a cooling device as defined in claim 1.

The cooling device is characterized in that the flow channels are elongated and arranged with their longitudinal axes inclined with respect to the cooling surface. Due to the inclined channels, the cooling capacity of the cooling device is improved. The reason for this is that the amount of material between the cooling surface and the cooling channels is increased, compared to having straight cannels, which improves the ability to conduct heat from the cooling surface to the cooling channels. A further advantage is that the cooling device has equally good cooling capacity on both sides of the device. Another advantage is that the cooling device according to the invention is easy to manufacture.

The angle between the longitudinal axes of the flow channels and an axis orthogonal to the cooling surface is between 10° and 15°. With an angle between 10° and 15°, an optimal relation between area of the channels and the area of material conducting away the heat is achieved, and accordingly an optimal cooling capacity is achieved.

By joining two or more extruded pieces, which are designed so that channels are formed between the pieces, it is possible to achieve very thin channels which have a very good cooling capacity.

The protruding elements are tapered towards their outer ends and the grooves are narrowed toward their bottoms. It is easier to extrude a piece having protruding elements which are tapered, compared to extruding a piece having a plurality of straight elements arranged close to each other. Thus, the pieces have shapes which make them suitable to be produced by extrusion. The pieces can be produced by using rather simple extruding tools. Further the shape of the pieces makes them easy to fit to each other, since they require less tolerance to fit together. The pieces can easily be fitted to each other. The pressing step as described in the prior art can be omitted. Thus, the cooling device is easy and cheep to manufacture.

The joining of the pieces can be made by means of simple and well-known methods, such as welding, soldering or gluing.

The device is, for example, a liquid cooler adapted to cool electronic components.

According to an embodiment of the invention, the ratio between the height and the width of the cooling cannels is more than 5, preferably more than 8, and most preferably more than 10. The invention makes it possible to achieve channels having a high ration between the height and the width of the cooling cannels. Such a channel has a small cross section area and a large wall area, and provides a very good cooling capacity.

According to an embodiment of the invention, the width of the flow channel is less than 10mm, preferably less than 5mm and most preferably less than 2mm. The invention makes it possible to have very thin channels. A further advantage with thin channels is that the number of channels on the same area can be increased, and accordingly the cooling efficiency can be increased.

According to an embodiment of the invention, the first and a second extruded piece are joined together by means of sealing joints. The sealing joints prevent the cooling fluid to escape from the channels and flow out of the device.

According to an embodiment of the invention, the first and a second extruded piece are joined together by means of friction stir welding (FSV). This method achieves a pore free and accordingly sealing joint.

According to an embodiment of the invention, the device is made of aluminum or an aluminum alloy. Aluminum is cheep and has suitable properties for extrusion.

According to an embodiment of the invention, the outer end of the protruding element and the bottom of the groove is designed to engage to each other in order to cold-weld the pieces together. By engaging the outer end of the protruding element to the bottom of the grooves, the outer surface of the device is prevented from bulging due to forces from the cooling fluid. If the cooling device is used for cooling components it is important that the surface, which is in contact with the component to be cooled, is very flat and not bulging.

According to an embodiment of the invention, the protruding elements and the corresponding grooves are designed such that one channel is formed on each side of the protruding element between the walls of the protruding element and the groove. By using both walls of the protruding element for creating flow channels, the number of channels per area is increased.

According to an embodiment of the invention, at least one of the inner and outer walls is provided with cooling fins. The cooling fins further increase the area of the walls of the channels and accordingly the cooling capacity of the cooling device. The cooling fins are easy to produce by the extrusion of two separate pieces.

The cooling device according to the invention is, for example, suitable for cooling electronic components or as a cooling part of a heat exchanger, for example in a heat pump.

Further developments of the device are characterized by the features of the additional claims.

### BRIEF DESCRIPTION OF THE DRAWINGS

The invention will now be explained more closely by the description of different embodiments of the invention and with reference to the appended figures.
Figure 1a shows an example of a top piece of a cooling device according to the invention in an elevation view.
Figure 1b shows a cross-sectional view through the top piece shown in figure 1a.
Figure 2a shows an example of a bottom piece of a cooling device according to the invention in an elevation view.
Figure 2b shows a cross-sectional view through the bottom piece shown in figure 2a.
Figure 3 shows a cooling device according to an embodiment of the invention including the top and bottom pieces shown in figures 1a-b and 2a-b.
Figure 4 shows an example of an extruding tool for producing the top piece shown in figures 1a-b.
Figure 5 shows an example of an extruding tool for producing the bottom piece shown in figures 2a-b.
Figure 6 shows a cross sectional view of a second example of the top piece.
Figure 7 shows a cross sectional view of a second example of the bottom piece.
Figure 8 shows a cross sectional view of a cooling device according to a second embodiment of the invention.
Figure 9 shows three extruded pieces for providing a heat exchanger.
Figure 10 shows a heat exchanger including a cooling device according to a third embodiment of the invention.

### DETAILED DESCRIPTION OF PREFERRED EMBODIMENTS OF THE INVENTION

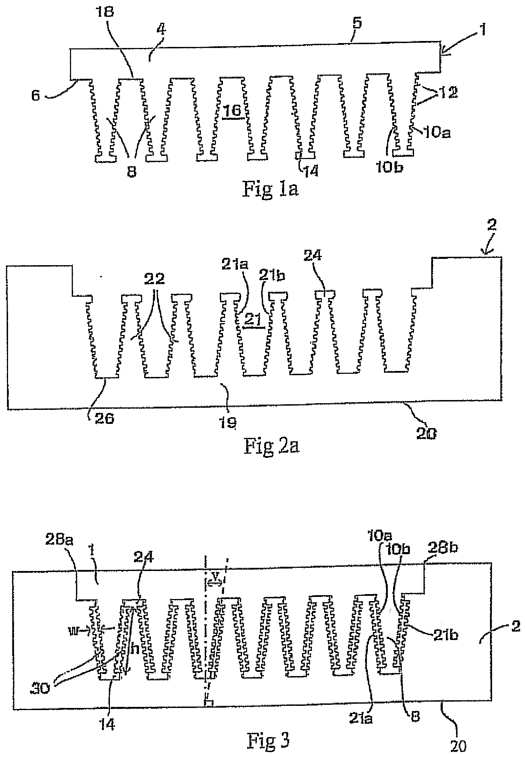

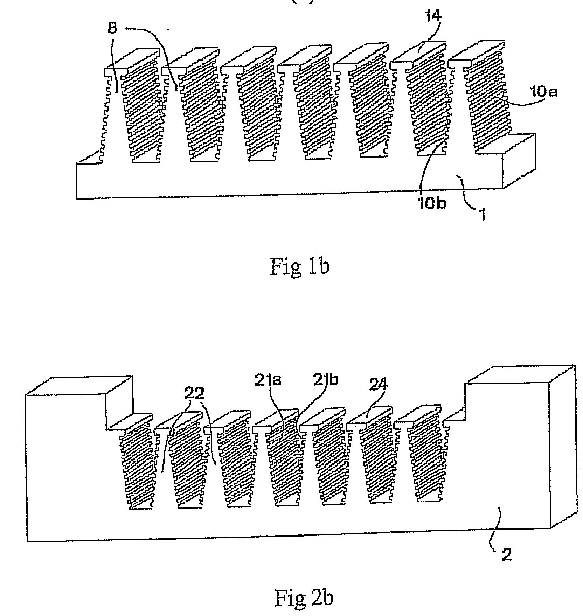

A cooling device according to the invention comprises a top and a bottom extruded piece, which are joined together. Figures 1a-b show an example of the top piece 1. Figure 1b shows a cross-sectional view through the top piece 1 shown in figure 1a. Figures 2a-b show an example of the bottom piece 2 of the cooling device. Figure 2b shows a cross-sectional view through the bottom piece 2 shown in figure 2a. As shown in the figures, the top and bottom pieces 1,2 have a fixed cross sectional profile.

The top piece 1 includes a base portion 4 having an outer surface 5 and an inner surface 6. A number of protruding elements in the form of ridges 8 are projecting from the inner surface 6 of the base portion. The ridges 8 extend along the entire length of the top piece 1. Each of the ridges 8 has two outer walls 10a, 10b on opposite sides of the ridge. In this embodiment the walls are provided with a plurality of surface enlargements 12, in the following called cooling fins. The purpose of the cooling fins 12 is to increase the surfaces of the walls 10a - b and thus to improve the cooling. The ridges 8 are tapering towards their outer ends. The outer end of each ridge 8 is provided with a locking member 14 designed to be engaged to the bottom piece 2. The top piece 1 also includes valleys 16 formed between the ridges 8. Each valley 16 includes a bottom part 18 designed to receive and engage a locking member of the bottom piece.

The bottom piece 2 includes a base portion 19 having an outer surface 20 adapted to be in contact with a component, which is to be cooled. The bottom piece 2 includes a plurality of grooves 21 having two opposite inner walls 21a-b. The walls 21a-b are provided with a plurality of cooling fins in the same way as the walls 10a-b of the top piece. The bottom piece includes a plurality of valleys and ridges 22, and the valleys form the grooves 21. The grooves 21 are narrowed toward their bottoms. The ridges 22 have the same shape as the ridges 8 of the first piece. The grooves 21 are formed between the ridges 22. The top and bottom pieces 1,2 are designed so that the each valley has a corresponding ridge on the opposite piece. The valleys and ridges are designed to fit to each other in such way that a slot is formed between the walls of the corresponding ridges and valleys when the pieces are connected to each other. Thus, the ridges 8,22 have a width that is slightly smaller than the width of the corresponding grooves 16,21. The height of the ridges and the corresponding grooves are the same to enable engagement of the outer end of the ridges to the bottom parts of the valleys.

The pieces 1,2 are preferably made of aluminium or an alloy of aluminium. Each groove 22 has a bottom part 26 designed to receive and engage the locking member 14 of a corresponding ridge 8 of the top piece. The width of the locking members 14, 24 is slightly larger than the width of the bottom parts 18, 26. When the locking members of the ridges are engaged to the bottom parts of the grooves they are cold welded together. By engaging the outer ends of the ridges to the bottom of the grooves, the outer surface of the device is prevented from bulging due to forces from the cooling fluid.

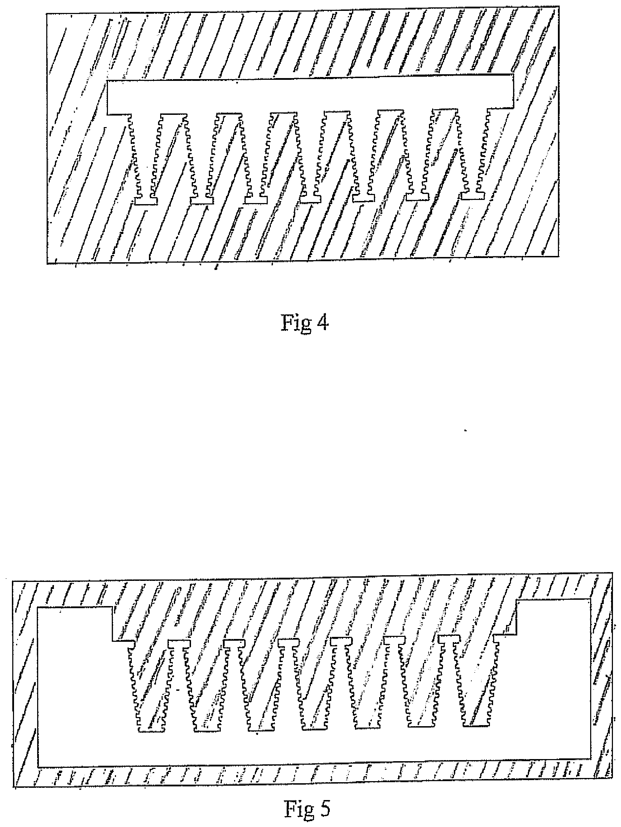

The top and the bottom pieces 1, 2 are produced by extrusion. Extrusion is a process used to create objects of a fixed cross sectional profile. The pieces are produced using a specially designed extrusion tool. The material, in a preferred embodiment the material is heated aluminium, is pushed through a tool of a desired cross section. Figure 4 shows an example of a tool for producing the top piece 1 shown in figure 1a-b, and figure 5 shows an example of a tool for producing the bottom piece 2 shown in figure 2a-b. The extrusion process is done with hot material. After the extrusion has been finished the pieces are cooled down.

Figure 3 shows an example of a cooling device according to the invention including a top piece 1 and a bottom piece 2, which has been joined together. The pieces are, for example, joined together by welding, soldering, or gluing. In a preferred embodiment of the invention, the pieces are joined together by means of Friction Stir Welding (FSW). Friction Stir Welding is a well known solid-state joining process and achieves pore free joints.

In this embodiment the cooling device has two joints 28a - b joining the two pieces together. The joins extends along the entire length of the cooling device. In this embodiment the joints are arranged to sealingly connect the two pieces together. However, in another embodiment it is possible to provide the sealing between the two pieces in other ways. For example, the two pieces can be joined together with screws and a separate sealing is arranged between the pieces.

When the pieces 1,2 are joined together the ridges 8 of the top piece are extending into the grooves 21 of the bottom piece, and the ridges 22 of the bottom piece are extending into the grooves 16 of the top piece. Thereby, a plurality of flow channels 30 is formed between the inner walls 21a-b of the grooves and the outer walls 10a-b of the ridges. The protruding elements and the corresponding grooves are designed such that at least one flow channel 30 is formed between the inner wall of the groove and the outer wall of the corresponding protruding element. The channels 30 are elongated and extend through the entire cooling device. The channels 30 are inclined with respect to the outer surface 20 adapted to be in contact with a component, which is to be cooled. As shown in the figure, the flow channels are arranged with their longitudinal axes angled with respect to the cooling surface. Preferably, the angle v between the longitudinal axes of the flow channels and an axis orthogonal to the cooling surface is between 5° and 45°, and more preferably between 10° and 15°. The flow channels are adapted to transport a cooling fluid through the cooling device in order to cool the base part 19 and the surface 20, which is adapted to be in contact with the object to be cooled. In another embodiment, both sides 5,19 of the cooling device can be in contact with objects to be cooled.

The channels 30 have a width w and a height h. In the example shown in figure 3, the width of the channels are about 1,5 mm and the ratio between the height and the width is about 10. The locking members 14, 24 of the ridges are attached to the bottom parts 18, 26 of the grooves by means of cold-welding. In a last step, the ends of the cooling device are provided with two covers, which are sealingly attached to the end parts of the top and bottom pieces in order to seal the ends of the flow channels.

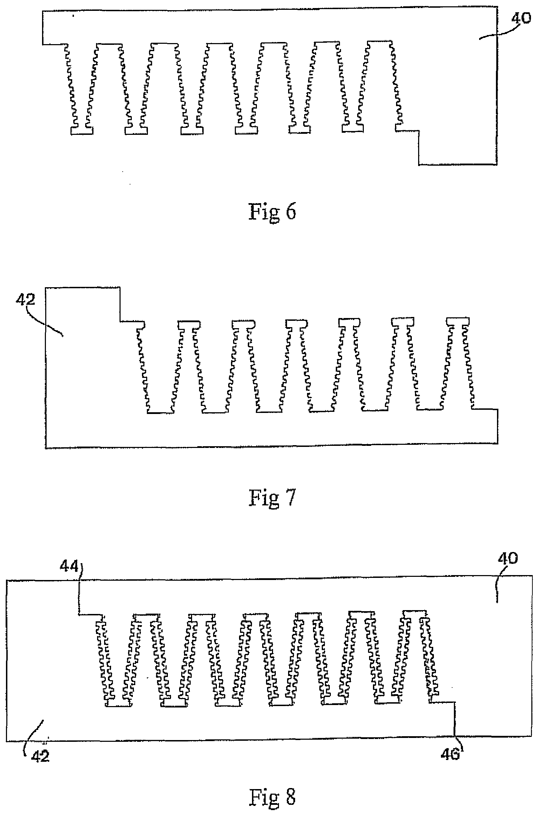

Figure 6 shows another example of an extruded top piece 40, and figure 7 shows another example of an extruded bottom piece 42. The shape of the pieces 40, 42 are identical. This embodiment of the invention is advantageous since one and the same tool can be used for producing both the top and the bottom piece of the cooling device.

Figure 8 shows a cooling device according to a second embodiment of the invention including the top and bottom pieces shown in figure 6 and 7. In this embodiment the joints 44, 46 between the first and second pieces are arranged on opposite sides of the device.

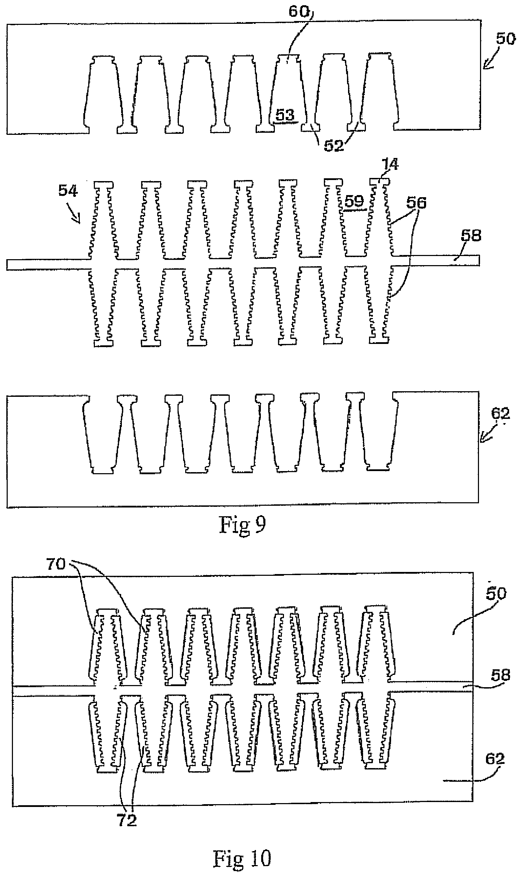

Figure 9 shows examples of three pieces 50,54,62 of a heat exchanger. A first piece 50 is provided with a plurality of protruding elements in the form of ridges 52 and plurality of grooves 53 in the form of valleys arranged between the ridges 52. In this embodiment, the walls of the ridges and accordingly the walls of the grooves are smooth and are not provided with cooling fins. A second piece 54 is provided with a plurality of ridges 56 protruding from a base part 58 on opposite sides of the base part. The second piece 54 is also provided with a plurality of grooves 59 in the form of valleys arranged between the ridges 56. The walls of the ridges 56 are provided with cooling fins. The upper ends of the ridges are provided with locking members 14 to be engaged to bottom parts 60 of the grooves 53. The cooling device also includes a third piece 62 designed in the same way as the first piece 50. The pieces 50,54,62 are extruded in the same way as described above.

Figure 10 shows a heat exchanger including a plurality of channels 70 for transportation of media of a first temperature and a plurality of channels 72 for transportation of media of a second temperature, which differs from the first temperature. The pieces 50,54,62 are joined together, for example, by welding.

The present invention is not limited to the embodiments disclosed but may be varied and modified within the scope of the following claims. For example, the design of the protruding elements and the grooves can be varied in many different ways. In another embodiment, the channels can be without any cooling fins.

## Claims

1. A cooling device including a cooling surface (20) adapted to be in contact with a component to be cooled, wherein the device comprises a first (2;40;50) extruded piece including a plurality of grooves (21;53) and a second (1;42;54) extruded piece including a plurality of protruding elements (8;56) extending into the grooves of the first piece, the first and second pieces are joined together and the protruding elements and the corresponding grooves are designed such that a plurality of flow channels for transportation of a cooling fluid (30;70) are formed between the grooves and corresponding protruding elements, the flow channels are elongated and **characterized in that** they are arranged with their longitudinal axes inclined with respect to the cooling surface by having the angle between the longitudinal axes of the flow channels and an axis orthogonal to the cooling surface between 5° and 45°.

2. The cooling device according to claim 1, wherein the angle between the longitudinal axes of the flow channels and an axis orthogonal to the cooling surface is between 10° and 15°.

3. The cooling device according to any of the previous claims, wherein the protruding elements (8;56) are tapered towards their outer ends and the grooves (21;53) are narrowed toward their bottoms.

4. The cooling device according to any of the previous claims, wherein the ration between the height (h) and the width (w) of the flow cannels (30) is more than 5, preferably more than 8, and most preferably more than 10.

5. The cooling device according to any of the previous claims, wherein the width (w) of the flow channels is less than 10mm, preferably less than 5mm and most preferably less than 2mm.

6. The cooling device according to any of the previous claims, wherein the first (2;40;50) and second (1;42;54) extruded pieces are joined together by means of Friction Stir welded joints.

7. The cooling device according to any of the previous claims, wherein the device is made of aluminum or an aluminum alloy.

8. The cooling device according to any of the previous claims, wherein the outer ends (14) of the protruding elements (8) and the bottom (26) of the grooves are designed to engage to each other in order to cold-weld the pieces together.

9. The cooling device according to any of the previous claims, wherein the protruding elements (8) and the corresponding grooves (21) are designed such that one channel (30) is formed on each side of the protruding element between the walls of the protruding element and the groove.

10. The cooling device according to any of the previous claims, wherein at least one of the inner (21a-b) and outer (10a-b) walls are provided with cooling fins (12).

11. The cooling device according to any of the previous claims, wherein the device is a liquid cooler adapted to cool electronic components.

12. Use of the cooling device according to any of the claims 1 - 11 for cooling electronic components.

13. Use of the cooling device according to any of the claims 1 - 11 in a heat exchanger.

## Patentansprüche

1. Kühlvorrichtung mit einer Kühlfläche (20), die so ausgebildet ist, dass sie in Kontakt mit einer zu kühlenden Komponente steht, wobei die Vorrichtung ein erstes (2; 40; 50) extrudiertes Teil mit einer Vielzahl von Nuten (21; 53) und ein zweites (1; 42; 54) extrudiertes Teil mit einer Vielzahl von vorstehenden Elementen (8; 56) umfasst, die sich in die Nuten des ersten Teils erstrecken, wobei das erste und das zweite Teil miteinander verbunden sind und die vorstehenden Elemente und die entsprechenden Nuten so gestaltet sind, dass eine Vielzahl von Strömungskanälen zum Transport eines Kühlfluids (30; 70) zwischen den Nuten und entsprechenden vorstehenden Elementen gebildet werden, die Strömungskanäle länglich sind und **dadurch gekennzeichnet, dass** sie so angeordnet sind, dass ihre Längsachsen in Bezug auf die Kühlfläche geneigt sind, indem der Winkel zwischen den Längsachsen der Strömungskanäle und einer zur Kühlfläche orthogonalen Achse zwischen 5° und 45° beträgt.

2. Kühlvorrichtung gemäß Anspruch 1, wobei der Winkel zwischen den Längsachsen der Strömungskanäle und einer zur Kühlfläche orthogonalen Achse zwischen 10° und 15° beträgt.

3. Kühlvorrichtung gemäß einem der vorhergehenden Ansprüche, wobei die vorstehenden Elemente (8; 56) zu ihren äußeren Enden hin konisch zulaufen und die Nuten (21; 53) zu ihren Böden hin verengt sind.

4. Kühlvorrichtung gemäß einem der vorhergehenden Ansprüche, wobei das Verhältnis zwischen der Höhe (h) und der Breite (w) der Strömungskanäle (30) mehr als 5, vorzugsweise mehr als 8 und am meisten bevorzugt mehr als 10 beträgt.

5. Kühlvorrichtung gemäß einem der vorstehenden Ansprüche, wobei die Breite (w) der Strömungskanäle weniger als 10 mm, vorzugsweise weniger als 5 mm und am meisten bevorzugt weniger als 2 mm beträgt.

6. Kühlvorrichtung gemäß einem der vorstehenden Ansprüche, wobei das erste (2;40;50) und das zweite (1;42;54) extrudierte Teil mittels Rührreibschweißen miteinander verbunden sind.

7. Kühlvorrichtung gemäß einem der vorstehenden Ansprüche, wobei die Vorrichtung aus Aluminium oder einer Aluminiumlegierung hergestellt ist

8. Kühlvorrichtung nach einem der vorstehenden Ansprüche, bei der die äußeren Enden (14) der vorstehenden Elemente (8) und der Boden (26) der Nuten so gestaltet sind, dass sie ineinander eingreifen, um die Teile kalt miteinander zu verschweißen.

9. Kühlvorrichtung gemäß einem der vorstehenden Ansprüche, wobei die vorstehenden Elemente (8) und die entsprechenden Nuten (21) so gestaltet sind, dass ein Kanal (30) auf jeder Seite des vorstehenden Elements zwischen den Wänden des vorstehenden Elements und der Nut gebildet wird.

10. Kühlvorrichtung gemäß einem der vorstehenden Ansprüche, bei der mindestens eine der inneren (21 a-b) und äußeren (10a-b) Wände mit Kühlrippen (12) versehen ist.

11. Kühlvorrichtung gemäß einem der vorstehenden Ansprüche, wobei die Vorrichtung ein Flüssigkeitskühler ist, der zur Kühlung elektronischer Komponenten geeignet ist.

12. Verwendung der Kühlvorrichtung nach einem der Ansprüche 1-11 zur Kühlung elektronischer Komponenten.

13. Verwendung der Kühleinrichtung nach einem der Ansprüche 1-11 in einem Wärmetauscher.

## Revendications

1. Dispositif de refroidissement comportant une surface de refroidissement (20) adaptée pour être en contact avec un composant à refroidir, dans lequel le dispositif comprend une première (2 ; 40 ; 50) pièce extrudée comportant une pluralité de rainures (21 ; 53) et une seconde (1 ; 42 ; 54) pièce extrudée comportant une pluralité d'éléments saillants (8 ; 56) s'étendant dans les rainures de la première pièce, les première et seconde pièces sont jointes ensemble et les éléments saillants et les rainures correspondantes sont conçus de sorte qu'une pluralité de canaux d'écoulement pour le transport d'un fluide de refroidissement (30 ; 70) soient formés entre les rainures et des éléments saillants correspondants, les canaux d'écoulement sont allongés et **caractérisé en ce qu'**ils sont agencés avec leurs axes longitudinaux inclinés par rapport à la surface de refroidissement, l'angle entre les axes longitudinaux des canaux d'écoulement et un axe orthogonal à la surface de refroidissement étant compris entre 5° et 45°.

2. Dispositif de refroidissement selon la revendication 1, dans lequel l'angle entre les axes longitudinaux des canaux d'écoulement et un axe orthogonal à la surface de refroidissement est compris entre 10° et 15°.

3. Dispositif de refroidissement selon l'une quelconque des revendications précédentes, dans lequel les éléments saillants (8 ; 56) sont effilés vers leurs extrémités extérieures et les rainures (21 ; 53) sont rétrécies vers leurs fonds.

4. Dispositif de refroidissement selon l'une quelconque des revendications précédentes, dans lequel le rapport entre la hauteur (h) et la largeur (w) des canaux d'écoulement (30) est supérieur à 5, de préférence supérieur à 8, et de manière préférée entre toutes supérieur à 10.

5. Dispositif de refroidissement selon l'une quelconque des revendications précédentes, dans lequel la largeur (w) des canaux d'écoulement est inférieure à 10 mm, de préférence inférieure à 5 mm et de manière préférée entre toutes inférieure à 2 mm.

6. Dispositif de refroidissement selon l'une quelconque des revendications précédentes, dans lequel les première (2 ; 40 ; 50) et seconde (1 ; 42 ; 54) pièces extrudées sont jointes ensemble au moyen de joints soudés par friction-malaxage.

7. Dispositif de refroidissement selon l'une quelconque des revendications précédentes, dans lequel le dispositif est réalisé en aluminium ou en alliage d'aluminium.

8. Dispositif de refroidissement selon l'une quelconque des revendications précédentes, dans lequel les extrémités extérieures (14) des éléments saillants (8) et le fond (26) des rainures sont conçus pour se mettre en prise les uns dans les autres afin de souder à froid les pièces ensemble.

9. Dispositif de refroidissement selon l'une quelconque des revendications précédentes, dans lequel les éléments saillants (8) et les rainures correspondantes (21) sont conçus de sorte qu'un canal (30) soit formé sur chaque côté de l'élément saillant entre les parois de l'élément saillant et la rainure.

10. Dispositif de refroidissement selon l'une quelconque des revendications précédentes, dans lequel au moins une des parois intérieure (21a-b) et extérieure (10a-b) est munie d'ailettes de refroidissement (12).

11. Dispositif de refroidissement selon l'une quelconque des revendications précédentes, dans lequel le dispositif est un refroidisseur de liquide adapté pour refroidir des composants électroniques.

12. Utilisation du dispositif de refroidissement selon l'une quelconque des revendications 1 à 11 pour refroidir des composants électroniques.

13. Utilisation du dispositif de refroidissement selon l'une quelconque des revendications 1 à 11 dans un échangeur de chaleur.
